# EUROPEAN PATENT APPLICATION

(11) **EP 4 692 814 A1**
(43) Date of publication of application: **11.02.2026**
(21) Application number: 24800237.0
(22) Date of filing: 02.05.2024
(51) Int. Cl.: G01R 31/367, G06T 7/00, G06V 10/82, G06N 20/20

(54) **MONITORING DEVICE AND OPERATION METHOD THEREOF**

(30) Priority: 02.05.2023 KR 20230057243
(71) Applicant: LG Energy Solution, Ltd., Seoul 07335 (KR)
(72) Inventor: PARK, Je Sung, Daejeon 34122 (KR); LEE, Seung Jun, Daejeon 34122 (KR); PARK, Jong Gyu, Daejeon 34122 (KR); CHO, Hyung Jun, Daejeon 34122 (KR); HONG, Seung Gyun, Daejeon 34122 (KR)
(74) Representative: BCKIP Part mbB
(86) International application number: PCT/KR2024/005947
(87) International publication number: WO 2024/228556

(57) **Abstract**

A monitoring apparatus, according to an embodiment disclosed in this document, may include a communication circuit, a processor, and a memory configured to store instructions, wherein the instructions may be executed by the processor for the monitoring apparatus to acquire an image of a battery through the communication circuit, determine whether the battery is defective by inputting the image into a first artificial intelligence model, determine, by inputting the image into a second artificial intelligence model based on whether the battery is determined as defective, whether the image has a different distribution from training data for classifying the battery as normal among training data used to train the first artificial intelligence model, and determine, based on whether the image has a different distribution from the training data, whether to retrain the first artificial intelligence model.

## Description

### [TECHNICAL FIELD]

### CROSS-REFERENCE TO RELATED APPLICATION

This application claims priority to and the benefit of Korean Patent Application No. 10-2023-0057243 filed in the Korean Intellectual Property Office on May 2, 2023, the entire contents of which are incorporated herein by reference.

### TECHNICAL FIELD

The embodiments disclosed in this document relate to a monitoring apparatus and operating method thereof.

### [BACKGROUND ART]

The demand for high-performance rechargeable batteries is increasing rapidly due to the growing popularity of portable electronic devices such as laptops, video cameras, and mobile phones, as well as the development of electric vehicles, energy storage systems, robots, and satellites.

Among the commercially available batteries such as nickel-cadmium, nickel-metal hydride, nickel-zinc, and lithium batteries, lithium batteries stand out due to their minimal memory effect compared to nickel-based batteries, allowing for more flexible charging and discharging, very low self-discharge rates, and high energy density.

### [DISCLOSURE]

### [TECHNICAL PROBLEM]

During the manufacturing and assembly process of batteries, problems with the appearance of battery pouches (e.g., dented corners, punctures, scratches, wrinkles, electrolyte contamination) may arise due to deformation, creasing, or damage to the sealing part of the battery casing. Given that defects in pouch appearance can compromise battery reliability and safety, it is important to detect defects in batteries (e.g., pouches) before they are distributed.

Visual inspection systems, commonly used to detect defects in batteries (e.g., pouches), collect and train on images of acceptable and defective products, then inspect batteries that have undergone manufacturing and assembly processes to check for appearance defects. However, if a new type of defect occurs that is not included in the trained defect types, there is a risk of the corresponding battery being misclassified as acceptable. Furthermore, the low occurrence rate of new defect types in the pouch manufacturing and assembly process makes it challenging to gather suitable defective product images for training the visual inspection system.

To address this limitation, the invention aims to enhance detection of new defect types, preventing the leakage of defective products.

The technical objects of the embodiments disclosed in this document are not limited to the aforesaid, and other objects not described herein with be clearly understood by those skilled in the art from the descriptions below.

### [TECHNICAL SOLUTION]

A monitoring apparatus, according to an embodiment disclosed in this document, may include a communication circuit, a processor, and a memory configured to store instructions, wherein the instructions may be executed by the processor for the monitoring apparatus to acquire an image of a battery through the communication circuit, determine whether the battery is defective by inputting the image into a first artificial intelligence model, determine, by inputting the image into a second artificial intelligence model based on whether the battery is determined as defective, whether the image has a different distribution from training data for classifying the battery as normal among training data used to train the first artificial intelligence model, and determine, based on whether the image has a different distribution from the training data, whether to retrain the first artificial intelligence model.

An operating method of a monitoring apparatus, according to an embodiment disclosed in this document, may include acquiring a battery image, determining whether the battery is defective by inputting the image into a first artificial intelligence model, determining, by inputting the image into a second artificial intelligence model based on whether the battery is determined as defective, whether the image has a different distribution from training data for classifying the battery as normal among training data used to train the first artificial intelligence model, and determining, based on whether the image has a different distribution from the training data, whether to retrain the first artificial intelligence model.

### [ADVANTAGEOUS EFFECTS]

According to various embodiments disclosed in this document, the monitoring apparatus is advantageous in terms of being capable of detect defective products with new types of defects that are not included in the stored training data, thereby preventing the leakage of defective products.

According to various embodiments disclosed in this document, the monitoring apparatus is advantageous in terms of being capable of improving the accuracy of defect detection by learning images of defective products with new defect types.

The advantageous effects of the monitoring apparatus and operating method thereof disclosed in this document are not limited to the aforesaid, and other effects not described herein with can be clearly understood by those skilled in the art from the descriptions below.

### [DESCRIPTION OF DRAWINGS]

FIG. 1 is a block diagram of a monitoring apparatus according to an embodiment of the disclosure;
FIG. 2 is a diagram illustrating an artificial intelligence model according to an embodiment disclosed in this document;
FIG. 3 is a diagram illustrating training data according to an embodiment in this document;
FIG. 4 is a diagram illustrating an artificial intelligence model according to another embodiment in this document;
FIG. 5 is a diagram illustrating a process of determining battery units as acceptable and defective according to an embodiment disclosed in this document;
FIGS. 6A and 6B are diagram illustrating a process of final determination of acceptable and/or defective battery units using artificial intelligence models according to an embodiment of the disclosure;
FIG. 7 is a flowchart illustrating an operating method of the monitoring apparatus according to an embodiment of the disclosure.
With regard to the explanation of the drawings, the same or similar reference numerals may be used for identical or similar components.

### [MODE FOR INVENTION]

Hereinafter, embodiments of the present invention are described with reference to accompanying drawings. However, the description is not intended to limit the present invention to particular embodiments, and it should be construed as including various modifications, equivalents, and/or alternatives of the embodiments described herein.

The embodiments and terms used in this document are not intended to limit the technical features disclosed in this document to specific embodiments, and should be understood to encompass various modifications, equivalents, or alternatives to the disclosed embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (such as importance or order), unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired or wirelessly) or indirectly (e.g., through a third component).

The methods according to various embodiments disclosed in this document can be included and provided in a computer program product. The computer program product may be traded between sellers and buyers as commodities. A computer program product can be distributed in the form of a device-readable storage medium (e.g., compact disc read-only memory, CD-ROM), or it can be distributed directly, online, between two user devices, or through an application store (e.g., download or upload). In the case of online distribution, at least part of the computer program product may be temporarily stored or temporarily created in a device-readable storage medium such as a manufacturer's server, an application store server, or a relay server's memory.

According to the embodiments disclosed in this document, each of the described components (e.g., modules or programs) may include one or more entities, and some of the plurality of entities may be separately arranged in other components. According to the embodiments disclosed in this document, one or more components or operations may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to the embodiments disclosed in this document, operations performed by modules, programs, or other components are executed sequentially, in parallel, iteratively, or heuristically, or one or more of the operations are executed in a different order, omitted, or one or more other operations may be added.

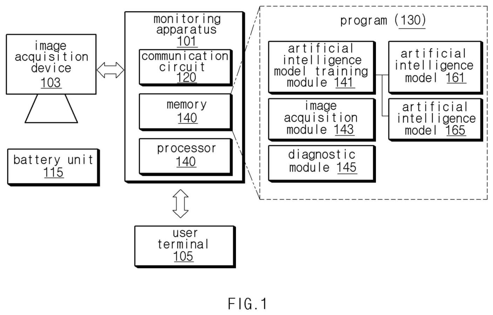

FIG. 1 is a block diagram illustrating a monitoring apparatus 101 according to an embodiment of the disclosure.

With reference to FIG. 1, the monitoring apparatus 101 according to an embodiment disclosed in this document may be connected to an image acquisition device 103 and a user terminal 105 through a wired and/or wireless connection.

In an embodiment, the connection between the monitoring apparatus 101 and the image acquisition device 103 may be a communication link through a wired and/or wireless network. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network encompassing 4G and 5G networks).

According to another embodiment, the connection between the battery anomaly diagnosis apparatus 101 and the image acquisition device 103 may be a connection established through an inter-device communication interface (e.g., bus, general purpose input and output (GPIO), serial peripheral interface (SPI), or mobile industry processor interface (MIPI)).

According to an embodiment, the connection between the battery anomaly diagnosis apparatus 101 and the user terminal 105 may be a communication link established through a wired and/or wireless network.

In an embodiment, the image acquisition device 103 may acquire images of the battery unit 115. According to an embodiment, the battery unit 115 may include a secondary battery. According to an embodiment, the secondary battery may encompass pouch-type secondary batteries, prismatic secondary batteries, and/or cylindrical secondary batteries.

The image acquisition device 103 may photograph the battery unit 115 to acquire images of the battery unit 115. According to an embodiment, the image acquisition device 103 may be implemented as a camera.

In an embodiment, the user terminal 105 may be a mobile device (e.g., portable phone, laptop computer, smartphone, and smart pad) or a personal computer (PC). In an embodiment, the user terminal 105 may be a terminal used by the administrator of the monitoring apparatus 101.

With reference to FIG. 1, the monitoring apparatus 101 may include a communication circuit 120, a memory 140, and a processor 150. According to an embodiment, the monitoring apparatus 101 shown in FIG. 1 may further include at least one component (e.g., a display, an input device, or an output device) in addition to the components illustrated in FIG. 1.

In an embodiment, the communication circuit 120 may establish a wired and/or wireless communication channel between the monitoring apparatus 101 and the image acquisition device 103 and/or user terminal 105 and exchange data with the image acquisition device 103 and/or the user terminal 105 through the established communication channel.

In an embodiment, the memory 140 may include volatile memory and/or nonvolatile memory.

In an embodiment, the memory 140 may store data used by at least one component (e.g., the processor 150) of the monitoring apparatus 101. For example, the data may include the program 130 (or instructions related thereto), input data, or output data. In an embodiment, when executed by the processor 150, the instruction may cause the monitoring apparatus 101 to perform operations defined by the instructions.

In an embodiment, the program 130 may include one or more software components (e.g., an artificial intelligence model training module 141, an image acquisition module 143, a diagnostic module 145, and one or more artificial intelligence models 161 and 165).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., an artificial intelligence model training module 141, an image acquisition module 143, a diagnostic module 145, and one or more artificial intelligence models 161 and 165) to control at least one other component (e.g., hardware or software component) of the monitoring apparatus 101 connected to the processor 150 and perform various data processing or operations.

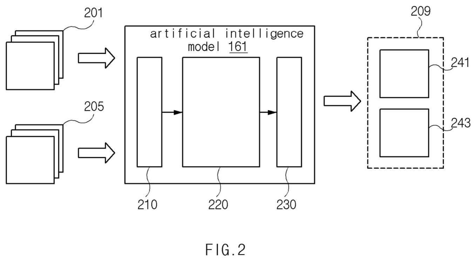

Hereinafter, a method of diagnosing abnormalities in the battery unit 115 using the monitoring apparatus 101 through the artificial intelligence model training module 141, image acquisition module 143, diagnostic module 145, and one or more artificial intelligence models 161 and 165 is described with reference to FIGS. 2 to 6B.

### First artificial intelligence model training

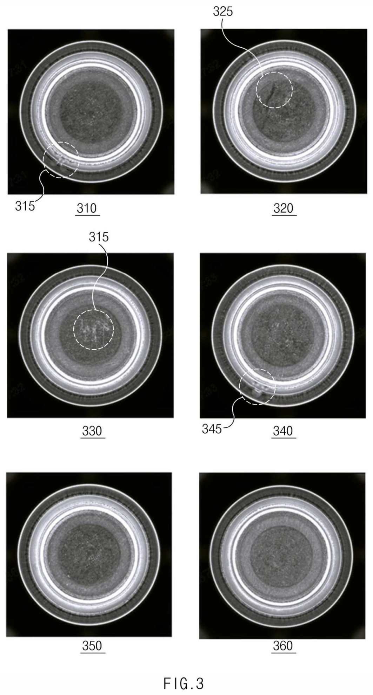

FIG. 2 is a diagram illustrating an artificial intelligence model 161 according to an embodiment disclosed in this document. FIG. 3 is a diagram illustrating training data according to an embodiment in this document.

In an embodiment, the artificial intelligence model training module 141 may train the artificial intelligence model 161 based on images 201 and 205 of battery units 115 that have already been acquired. Here, the images 201 and images 205 may be previously acquired training data. The images 201 may refer to images intended to classify battery unit 115 as normal in the training data. The images 205 may refer to images intended to classify battery unit 115 as defective in the training data. In an embodiment, images 201 and images 205 can include whole-unit images capturing the entire battery unit 115 or close-up images focusing on specific parts of the battery unit 115. In an embodiment, when the images 201 and images 205 consist of whole-unit images, images 201 may include images of battery units 115 classified as normal, while images 205 may include images of battery units 115 classified as defective. In an embodiment, when the images 201 and images 205 consist of close-up images, images 201 may include images of battery unit 115 divided into images for each inspection item (e.g., dents, creases, printed text, and welds), classified as normal, while images 205 may include images of battery unit 115 divided into images for each inspection item, classified as defective.

For example, the images 310, 320, 330, and 340 in FIG. 3 may be images of battery units 115 classified as defective. For example, the images 310 and 340 may be images containing dents 315 and 345 outside the normal range, while images 320 and 330 may be images containing scratches 325 and 335 outside the normal range. Similarly, the images 350 and 360 may be images of battery units 115 classified as normal.

In an embodiment, the artificial intelligence model 161 may be a model capable of multi-class classification (e.g., a model based on convolutional neural network (CNN)). In an embodiment, the artificial intelligence model 161 may be trained to classify the normality and defectiveness of battery units 115 based on the images 201 and 205 of the battery units 115. In an embodiment, the artificial intelligence model 161 may be trained to classify the normality and defectiveness of each inspection item of battery units 115 based on the images 201 and 205 of the battery units 115.

In an embodiment, the artificial intelligence model 161 may include an input layer 210, a hidden layer 220, and an output layer 230. Here, the input layer 210 may receive the previously acquired images 201 and images 205 of battery units 115. The hidden layer 220 may have a structure where multiple layers are sequentially connected. The output layer 230 may be a layer designed to output the multi-class classification result 209 of each of the images 201 and images 205. In an embodiment, the multi-class classification result 209 may include probability values for classes 241 and 243 corresponding to inspection items for the images 201 and images 205. For example, the class 241 may represent the probability of the battery unit 115 being normal, while the class 243 may represent the probability of the battery unit 115 being defective. In an embodiment, the classes 241 and 243 may be more than two in number. For example, additional classes representing normal and defective for each inspection item (e.g., dents, scratches, or creases) may also be included.

In an embodiment, the artificial intelligence model training module 141 may adjust the parameters of the hidden layer 220 by inputting the images 201 and images 205 into the artificial intelligence model 161 to ensure that the obtained multi-class classification result 209 matches or has a difference value below a predetermined threshold with the pre-classification results of images 201 and images 205, respectively.

### Second artificial intelligence model training

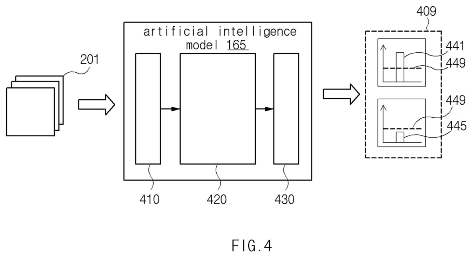

FIG. 4 is a diagram illustrating an artificial intelligence model 165 according to an embodiment disclosed in this document.

In an embodiment, the artificial intelligence model training module 141 may train the artificial intelligence model 165 based on images 201 of battery units 115 that have already been acquired. Here, the images used to train the artificial intelligence model 165 may be images from the training data classifying battery units 115 as normal.

In an embodiment, the artificial intelligence model 165 may be a model capable of multi-class classification (e.g., a model based on CNN). In an embodiment, the artificial intelligence model 165 may be trained to output similarity for each inspection item relative to normal images based on the images 201 of battery units 115. Here, similarity may refer to the maximum probability value obtained from the multi-class classification results generated by the artificial intelligence model 165.

In an embodiment, the artificial intelligence model 165 may be trained to compare the similarity based on the images 201 of battery units 115 with a threshold value to determine whether the image corresponds to in-distribution (i.e., corresponds to images of previously trained acceptable products) or out-of-distribution (i.e., corresponds to images of new types of defective products).

In an embodiment, the artificial intelligence model 165 may include an input layer 410, a hidden layer 420, and an output layer 430. Here, the input layer 410 may receive the previously acquired images 201 of battery units 115. The hidden layer 420 may have a structure where multiple layers are sequentially connected. The output layer 430 may be a layer designed to output the multi-class classification result 409 of each of the images 201. In an embodiment, the multi-class classification result 409 may include probability values for classes corresponding to inspection items for the images 201. The classes set in the artificial intelligence model 165 may be fewer than the classes set in the artificial intelligence model 161. For example, the artificial intelligence model 165 may only have classes representing normal conditions.

In an embodiment, the artificial intelligence model training module 141 may adjust the parameters of the hidden layer 420 by inputting the images 201 into the artificial intelligence model 165 to ensure the maximum value 441 of the probabilities based on the obtained multi-class classification result 409 exceeds a threshold value 449.

In an embodiment, the artificial intelligence model training module 141 may test the artificial intelligence model 165 using the image 205. For example, the artificial intelligence model training module 141 may determine whether the maximum value 445 of the probabilities based on the multi-class classification result 409 of the images 205 is equal to or less than a threshold value 449. In an embodiment, when the maximum value 445 of the probabilities based on the multi-class classification result 409 of the images 205 is greater than the threshold value 449, the artificial intelligence model training module 141 may adjust the threshold value 449 of the artificial intelligence model 165. For example, the artificial intelligence model training module 141 may adjust the threshold value 449 based on a baseline algorithm or the ODIN (out-of-distribution detector for neural networks) algorithm. Here, the adjustment of the threshold value 449 may be distinct from the training process of adjusting the parameters of the hidden layer 420.

### Defect detection of battery unit

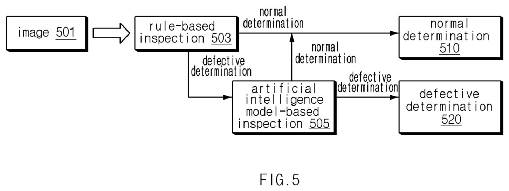

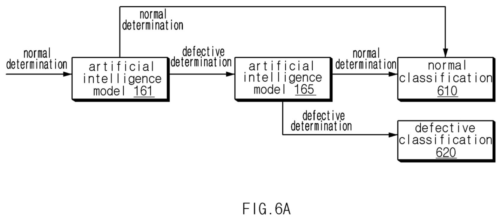

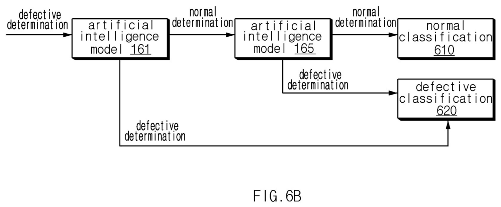

FIG. 5 is a diagram illustrating a process of determining a battery unit 115 as acceptable and defective according to an embodiment disclosed in this document. FIGS. 6A and 6B are diagram illustrating a process of final determination of acceptable and/or defective battery units using artificial intelligence models 161 and 165 according to an embodiment of the disclosure.

In an embodiment, the processor 150 may detect normal and/or defective battery units 115 through the diagnostic module 145. The processor 150 may classify battery units 115 as normal or defective to detect normal and/or defective units, through the diagnostic module 145. The processor 150 may classify battery units 115 as normal or defective based on the pre-stored training data through the diagnostic module 145. In the following, the operations of the processor 150 can be understood as being performed through the diagnostic module 145 unless otherwise stated.

In an embodiment, the processor 150 may determine a battery unit 115 as normal or defective by performing rule-based inspection 503 based on the images 501 of the battery units 115. Here, the rule-based inspection 503 may refer to image-based inspection for each inspection item related to the appearance of battery units 115 (e.g., presence of jellyroll, dents, and creases). For example, the processor 150 may distinguish dents and creases on jellyroll based on the area and pressure magnitude applied to the jellyroll included in the image 501. For example, creases and dents on the jellyroll may be distinguished based on color differences in the image 501. Here, the inspection items may include not only the presence of jellyroll, dents, and creases, but also inspection items related to the outer diameter size and cathode roundness. In an embodiment, the criteria for determining whether a battery unit 115 is normal or defective based on visual inspection may be set according to the specifications of the battery unit 115.

In an embodiment, when the rule-based inspection 503 determines that the battery unit 115 is defective, the processor 150 further inspect the battery unit 115 to determine whether it is normal or defective based on the artificial intelligence model-based inspection 505 using the images 501. In an embodiment, the artificial intelligence model used in the artificial intelligence model-based inspection 505 may be distinct from both the artificial intelligence model 161 and the artificial intelligence model 165.

In an embodiment, when the battery unit 115 is determined as normal during the rule-based inspection 503 or during the artificial intelligence model-based inspection 505, the processor 150 may make a normal determination 510. However, when the battery unit 115 is determined as defective during both the rule-based inspection 503 and the artificial intelligence model-based inspection 505, the processor may make a defective determination 520.

The rule-based inspection 503 and the artificial intelligence model-based inspection 505 included in process of FIG. 5 are provided as examples, and normal determination 510 or defective determination 520 may be made based on either the rule-based inspection 503 or the artificial intelligence model-based inspection 505.

In the case of a normal determination 510, the processor 150 may perform classification operations according to FIG. 6A. In the case of a defective determination 520, the processor 150 may perform classification operations according to FIG. 6B.

With reference to FIGS. 6A and 6B, the processor 150 may input an image of the battery unit 115 into the artificial intelligence model 161 to determine whether the battery unit 115 is normal or defective.

In an embodiment, when the determination result of the artificial intelligence model 161 is the same as the previous determination, the processor 150 may choose not to perform the determination based on the artificial intelligence model 165. For example, when the battery unit 115 is determined as normal based on the rule-based inspection 503 and/or the artificial intelligence model-based inspection 505, and also determined as normal based on the artificial intelligence model 161, the processor 150 may classify the battery unit 115 under the normal classification 610. For another example, when the battery unit 115 is determined as defective based on the rule-based inspection 503 and/or the artificial intelligence model-based inspection 505, and also determined as defective based on the artificial intelligence model 161, the processor 150 may classify the battery unit 115 under the defective classification 620.

In an embodiment, when the determination result of the artificial intelligence model 161 differs from the previous determination, the processor 150 may choose to perform the determination based on the artificial intelligence model 165. For example, when the battery unit 115 is determined as defective based on the rule-based inspection 503 and artificial intelligence model-based inspection 505, but determined as normal based on the artificial intelligence model 161, the processor 150 may finally determine of whether the battery unit 115 is normal or defective through the artificial intelligence model 165. For another example, when the battery unit 115 is determined as normal based on the rule-based inspection 503 and artificial intelligence model-based inspection 505, but determined as defective based on the artificial intelligence model 161, the processor 150 may finally determine whether the battery unit 115 is normal or defective through the artificial intelligence model 165.

In an embodiment, the processor 150 may determine, based on the artificial intelligence model 165, whether the image of the battery unit 115 has a different distribution from the training data for classifying battery unit 115 as normal among the training data used to train the artificial intelligence model 161 (i.e., out of distribution). In an embodiment, the processor 150 may detect new types of defective products by comparing the similarity obtained by inputting the image of the battery unit 115 into the artificial intelligence model 165 with a threshold value. Here, similarity may refer to the maximum probability value obtained from the multi-class classification results generated by the artificial intelligence model 165. For example, when the similarity is exceeds the threshold value, the processor 150 may classify the battery unit 115 as normal. For another example, when the similarity is below the threshold value, the processor 150 may classify the battery unit 115 as defective. In an embodiment, the battery units 115 reclassified as defective may indicate new types of defective products.

In an embodiment, the processor 150 may retrain the artificial intelligence model 161 based on the images used in reclassifying the battery unit 115 as defective. In an embodiment, the images used when the battery unit 115 is reclassified as defective may be utilized as images for classifying the battery unit 115 as defective.

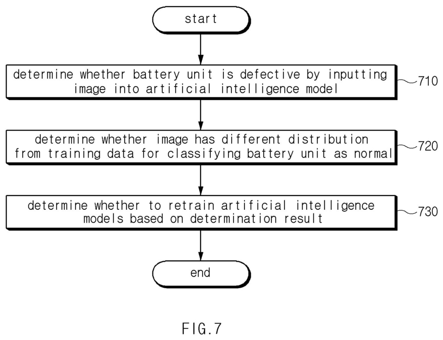

FIG. 7 is a flowchart illustrating an operating method of the monitoring apparatus according to an embodiment of the disclosure. FIG. 7 may be explained with reference to FIGS. 1 to 6B.

With reference to FIG. 7, in operation 710, the monitoring apparatus 101 may input an image into the artificial intelligence model 161 to determine whether the battery unit 115 is defective. Here, the artificial intelligence model 161 may be a model trained based on previously acquired training data to classify the battery unit 115 as normal or defective. The previously acquired training data may include images for classifying the battery unit 115 as normal and images for classifying the battery unit 115 as defective.

In operation 720, the monitoring apparatus 101 may determine whether the image has a different distribution from the training data for classifying the battery unit 115 as normal.

In an embodiment, the monitoring apparatus 101 may determine whether the image has a different distribution from the training data for classifying the battery unit 115 as normal, based on the determination result of the battery unit 115 made by inputting the image into the artificial intelligence model 161 to determine defectiveness. For example, when the determination result of the artificial intelligence model 161 is the same as the previous determination result, the monitoring apparatus 101 may choose not to perform the determination based on the artificial intelligence model 165. Here, the previous determination may be based on the rule-based inspection 503 and/or the artificial intelligence model-based inspection 505.

In an embodiment, when the determination result of the artificial intelligence model 161 is different from the previous determination result, the monitoring apparatus 101 may perform the determination based on the artificial intelligence model 165.

In an embodiment, the monitoring apparatus 101 may determine whether the image of the battery unit 115, based on the artificial intelligence model 165, has a different distribution from the training data for classifying the battery unit 115 as normal among the training data used to train the artificial intelligence model 161 (i.e., out of distribution). In an embodiment, the monitoring apparatus 101 may detect new types of defective products by comparing the similarity obtained by inputting the image of the battery unit 115 into the artificial intelligence model 165 with a threshold value. Here, similarity may refer to the maximum probability value obtained from the multi-class classification results generated by the artificial intelligence model 165. For example, when the similarity is exceeds the threshold value, the monitoring apparatus 101 may classify the battery unit 115 as normal. For another example, when the similarity is below the threshold value, the monitoring apparatus 101 may classify the battery unit 115 as defective. In an embodiment, the battery units 115 reclassified as defective may indicate new types of defective products.

In operation 730, the monitoring apparatus 101 may determine whether to retrain the artificial intelligence model 161 based on the determination result. In an embodiment, when the image has a different distribution from the training data (i.e., out of distribution), the monitoring apparatus 101 may determine that retraining of the artificial intelligence model 161 is necessary.

## Claims

1. A monitoring apparatus comprising:
a communication circuit;
a processor; and
a memory configured to store instructions,
wherein the instructions are executed by the processor for the monitoring apparatus to acquire an image of a battery through the communication circuit, determine whether the battery is defective by inputting the image into a first artificial intelligence model, determine, by inputting the image into a second artificial intelligence model based on whether the battery is determined as defective, whether the image has a different distribution from training data for classifying the battery as normal among training data used to train the first artificial intelligence model, and determine, based on whether the image has a different distribution from the training data, whether to retrain the first artificial intelligence model.

2. The monitoring apparatus of claim 1, wherein the instructions are executed by the processor for the monitoring apparatus to determine whether the battery is defective based on an algorithm different from the first and second artificial intelligence models, and determine, in response to the determination result based on the different algorithm being different from the determination result through the first artificial intelligence model, whether the image has the different distribution through the second artificial intelligence model.

3. The monitoring apparatus of claim 2, wherein the instructions are executed by the processor for the monitoring apparatus to determine whether the image is defective based on a rule-based algorithm, and determine, in response to the determination result based on the rule-based algorithm indicating the battery as defective, whether the image is defective through the first and second artificial intelligence models.

4. The monitoring apparatus of claim 1, wherein the instructions are executed by the processor for the monitoring apparatus to determine finally the battery as normal based on the image having the same distribution as the training data, and as defective based on the image having a different distribution from the training data.

5. The monitoring apparatus of claim 1, wherein the second artificial intelligence model is trained based on the training data for classifying the battery as normal, and the first artificial intelligence model is trained based on the training data for classifying the battery as normal and the training data for classifying the battery as defective.

6. An operating method of a monitoring apparatus, the method comprising:
acquiring a battery image;
determining whether the battery is defective by inputting the image into a first artificial intelligence model;
determining, by inputting the image into a second artificial intelligence model based on whether the battery is determined as defective, whether the image has a different distribution from training data for classifying the battery as normal among training data used to train the first artificial intelligence model; and
determining, based on whether the image has a different distribution from the training data, whether to retrain the first artificial intelligence model.

7. The method of claim 6, further comprising:
determine whether the battery is defective based on an algorithm different from the first and second artificial intelligence models,
wherein the determining of whether the image has a different distribution comprises determining, in response to the determination result based on the different algorithm being different from the determination result through the first artificial intelligence model, whether the image has a different distribution through the second artificial intelligence model.

8. The method of claim 7, wherein the determining of whether the battery is defective based on a different algorithm comprises:
determining whether the image is defective based on a rule-based algorithm; and
determining, in response to the determination result based on the rule-based algorithm indicating the battery as defective, whether the image is defective through the first and second artificial intelligence models.

9. The method of claim 6, further comprising determining finally the battery as normal based on the image having the same distribution as the training data, and as defective based on the image having a different distribution from the training data.

10. The method of claim 6, wherein the second artificial intelligence model is trained based on the training data for classifying the battery as normal, and the first artificial intelligence model is trained based on the training data for classifying the battery as normal and the training data for classifying the battery as defective.
